# EUROPÄISCHE PATENTSCHRIFT

(11) **EP 3 102 717 B1**
(45) Veröffentlichungstag und Bekanntmachung des Hinweises auf die Patenterteilung: **15.01.2020**
(21) Anmeldenummer: 15704736.6
(22) Anmeldetag: 04.02.2015
(51) Int. Cl.: C23C 16/458, H01L 21/673, H01L 21/677, C23C 16/32, C23C 16/34, C23C 16/50

(54) **SCHUTZSCHICHT FÜR PECVD-BOOTE AUS GRAPHIT**
PROTECTIVE LAYER FOR PECVD GRAPHITE BOATS
COUCHE PROTECTRICE POUR NACELLES PECVD EN GRAPHITE

(30) Priorität: 06.02.2014 DE 102014101497
(43) Veröffentlichungstag der Anmeldung: 14.12.2016
(73) Patentinhaber: KGT Graphit Technologie GmbH, 53578 Windhagen (DE)
(72) Erfinder: KORNMEYER, Torsten, 53639 Königswinter (DE)
(74) Vertreter: Lippert Stachow Patentanwälte Rechtsanwälte Partnerschaft mbB
(86) Internationale Anmeldenummer: PCT/EP2015/052255
(87) Internationale Veröffentlichungsnummer: WO 2015/117991

(56) Entgegenhaltungen:
- EP-A1- 0 143 479
- EP-A2- 2 053 649
- WO-A1-02/20871
- US-A- 6 120 640
- US-A1- 2008 050 522
- US-A1- 2009 155 028
- US-A1- 2012 279 443
- US-A1- 2013 302 616

## Beschreibung

Die Erfindung betrifft eine Schutzschicht für PECVD-Boote aus Graphit zur Aufnahme von Wafern und zum Transport derselben in oder durch PECVD-Beschichtungsanlagen, insbesondere in der Photovoltaikindustrie.

Unter PECVD (Plasma enhanced chemical vapor deposition) ist eine Beschichtung von Oberflächen mit Unterstützung durch ein Plasma zu verstehen.

PECVD-Boote, die auch als Waferboote bezeichnet werden, bestehen gewöhnlich aus Graphit und dienen dazu, möglichst viele Wafer aus Glas, Silizium, oder anderen für die Fertigung von Solarzellen geeigneten Materialien sicher aufzunehmen, so dass eine Handhabung und Lagerung der bestückten Waferboote ohne Gefahr einer Beschädigung der Wafer sicher möglich ist. Die Waferboote müssen dazu mit geeigneten Halterungen, wie Wafertaschen oder Haltepins, ausgestattet sein. Weiterhin müssen die einzelnen Wafer im Waferboot in einem Abstand zueinander gehalten werden, um ein möglichst gleichmäßiges Durchströmen von Gasen durch sämtliche Zwischenräume zwischen den Wafern zu ermöglichen.

Außerdem dürfen die PECVD-Boote die Ausbildung eines Plasmas zwischen den einzelnen Wafern im Interesse einer gleichmäßigen Beschichtung nicht behindern.

In der DE 10 2008 019 023 A1 werden eine Vakuum-Durchlaufanlage zur Prozessierung von Substraten mittels PECVD, sowie ein Plasmaboot (Waferboot) zur Aufnahme und zum Transport von Wafern durch die Vakuum-Durchlaufanlage, beschrieben.

Um die Ausbildung eines Plasmas während des Beschichtungsvorganges auch zwischen den Wafern zu ermöglichen, sind entweder Zwischenträger aus einem leitfähigen Material, wie Graphit, vorgesehen, die zusammen mit einer geeigneten Wechselspannungszuführung als Antennen wirken, oder das Waferboot besteht insgesamt aus Graphit.

Weiterhin muss auf einer Solarzelle (Si-Substrat) eine Antireflexionsschicht mit einer geeigneten Plasma-CVD-Anlage aufgetragen werden, um den bestmöglichen Wirkungsgrad zu erreichen. Das erfolgt gewöhnlich durch Auftragen einer Siliziumnitrid- oder -oxidschicht auf die Oberfläche des Substrates mittels eines PECVD-Prozesses.

Einzelheiten eines solchen recht komplizierten Prozesses gehen aus der DE 10 2012 101 456 A1 hervor.

Um nun eine möglichst homogene Antireflex-Beschichtung aus Siliziumnitrid auf dem Si-Substrat zu erreichen, ist es üblich, die PECVD-Boote vorab mit einer vergleichsweise dicken Siliziumnitrid-Beschichtung mit einer Schichtdicke von etwa 1 µm zu versehen. Dazu müssen die PECVD-Boote in einem Ofen bei einer Temperatur von über 480 °C einer Atmosphäre ausgesetzt werden, die Silan (SiH₄) und Ammoniak (NH₃) enthält, so wie dies etwa in der WO 03/025248 A1 am Beispiel des Abscheidens von Siliziumnitrid auf einem Substrat beschrieben wird.

Werden PECVD-Boote ohne eine solche Siliziumnitrid-Beschichtung verwendet, so hat sich gezeigt, dass eine ausreichend homogene Antireflex-Beschichtung nicht hergestellt werden kann. Der Grund hierfür ist darin zu sehen, dass der elektrische Oberflächenwiderstand bzw. die Leitfähigkeit von Graphit des Waferbootes und Silizium des Siliziumsubstrates zu unterschiedlich ist.

Problematisch und kostenintensiv ist hier, dass es nach 40 bis 100 Beschichtungsprozessen erforderlich ist, die Siliziumnitrid-Beschichtung auf dem PECVD-Boot mittels HF (Flusssäure)-Nassätzen unter Zugabe von Sauerstoff rückzuätzen und die Beschichtung anschließend erneut aufzutragen.

Das bedeutet, dass für das regelmäßige Beschichten der PECVD-Boote ein zusätzlicher Aufwand und somit zusätzliche Kosten anfallen, was gleichzeitig zu einer Verringerung der Verfügbarkeit der Produktionsanlagen zum Herstellen der Antireflex-Beschichtung, d. h. der PECVD-Anlage, um 8 - 10 % führt, da die Siliziumnitrid-Beschichtung in der gleichen PECVD-Anlage durchgeführt wird, wie die Antireflexbeschichtung. Die Folge sind erhöhte Waferkosten.

Außerdem tritt beim Rückätzen der PECVD-Boote durch den Sauerstoff ein zusätzlicher Verschleiß ein. Ein weiterer Nachteil besteht darin, dass sich bei den PECVD-Booten mit Siliziumnitrid-Beschichtung hinter dem Siliziumsubstrat keine sauerstoffresistente Schutzschicht befindet.

Aus der US 2009/155028 A1 geht ein scheibenförmiger Waferträger für einen Drehteller-CVD Reaktor hervor, der aus einem nicht-metallischen temperaturfesten Material, vorzugsweise einem keramischen Material, wie Siliziumcarbid, Bornitrid, Borcarbid, Aluminiumnitrid, Aluminium, Saphir, Quarz, Graphit oder Kombinationen davon, besteht. Der Drehteller kann aber auch mit einer Beschichtung aus einem Metallcarbid, -oxid, -nitrid, wie Titancarbid oder Tantalcarbid versehen sein.

Mit der Wahl des Materials, oder der Beschichtung für den Drehteller, soll eine Unempfindlichkeit gegen hohe Temperaturen erreicht, sowie eine Reaktion mit den im Prozess eingesetzten Gasen verhindert werden.

Weiterhin bezieht sich die US 2008/0050522 A1 auf ein Verfahren zum Aufbringen von Schutzschichten auf einem Graphitblock. Bei den Schutzschichten handelt es sich um Titannitrid und Titancarbid mit verschiedenen Zwischenschichten als Pufferschichten.

Mit diesen Schutzschichten soll eine hohe elektrische Leitfähigkeit, eine hohe chemische Stabilität und eine hohe Widerstandsfähigkeit gegen mechanische und abrasive Belastungen erreicht werden.

Aus der US 2013/302616 A1 gehen ein Verfahren zur Beschichtung eines Graphitmaterials mit einem pyrolytischen Bornitrid (PBN), sowie ein mit diesem Verfahren beschichteter Artikel hervor. Dazu muss zunächst eine oberflächliche Verdichtung des Graphitmaterials erfolgen, wofür eine CVI-Behandlung (CVI = Chemical Vapor Infiltration, Chemische Gasphaseninfiltration) eingesetzt wird und anschließend kann die PBN-Beschichtungsschicht hergestellt werden. Die CVI Behandlung erfolgt bei 1000°C unter Zuführung von Methangas und die Herstellung der PBN-Beschichtung erfolgt durch Zuführung von BCl₃ bei 1.400°C und schließlich von NH₃ bei 2000°C.

Dabei entsteht unter der PBN-Beschichtung unbeabsichtigt Borcarbid an der Grenzfläche zum Graphitkernkörper infolge der Behandlung der Oberfläche mit dem reaktiven Gas BCl₃.

In der US 2008/0050522 A1 wird ein Verfahren zur Herstellung einer Schutzschicht auf einem Susceptor beschrieben, der aus einem Graphitblock besteht. Vor der Beschichtung wird der Graphitblock bei 1100°C bis 1200°C einem thermischen Korrosionsprozess unterzogen, um metallische Unreinheiten zu beseitigen. Danach wird eine Zwischenschicht auf dem Graphitblock erzeugt und auf dieser ein Titannitridfilm bei 700°C bis 1200° C durch ein CVD-Verfahren mittels eines Precursors in Form von Titantetrachlorid und Ammoniak als Transportgas abgeschieden. In einem weiteren CVD-Verfahren wird bei gleichen Temperaturen ein Titancarbidfilm aus den Precursoren Titantetrachlorid und Titantetrabromid mit Wasserstoff als Trägergas auf einer zweiten Zwischenschicht abgeschieden. Damit soll der Energieverbrauch infolge der geringen Wärmeleitfähigkeit verringert werden.

Schließlich werden in der US 6 120 640 A Borcarbidbeschichtungen in einem Plasmareaktor beschrieben, dessen Prozessraum aus einem oberen Gehäuseteil aus einer Aluminiumlegierung besteht, das mit einem gewölbten Keramikdeckel verschlossen ist. Weiterhin ist eine vertikal verfahrbare Platte 16 mit einem Chuck zum Halten eines Wafers vorgesehen, die den Prozessraum verschließt.

Wenn nun im Prozessraum ein hochdichtes BCl₃ Plasma erzeugt wird, erfolgt ein Al-Ätzen und die Kammerwand wird geschädigt. Um das zu verhindern, wird die Innenwand des Gehäuseteils Borcarbid beschichtet. Erwähnt wird jedoch, dass Borcarbid auch auf anderen Materialien, wie Graphit abgeschieden werden kann.

Der Erfindung liegt nun die Aufgabe zugrunde, eine Schutzschicht für PECVD-Boote ohne die beschriebenen Nachteile zu schaffen und mit der zugleich die Herstellung einer besseren und homogeneren Antireflexschicht auf Siliziumsubstraten ermöglicht wird.

Es hat sich überraschend erwiesen, dass die der Erfindung zugrunde liegende Aufgabe mit einer Schutzschicht für PECVD-Boote aus Graphit zur Aufnahme von Wafern und zum Transport derselben in oder durch PECVD-Beschichtungsanlagen, insbesondere in der Photovoltaikindustrie, wobei das aus Graphit oder Carbon bestehende PECVD-Boot eine elektrisch leitfähigen Hartstoff-Beschichtung mit einem mehrschichtigen Aufbau, bestehend aus Titannitrid und/oder Titancarbid, aufweist, dadurch gelöst wird, dass die elektrisch leitfähige Hartstoff-Beschichtung Borcarbid, bestehend aus in einer PECVD-Beschichtungsanlage, oder einem Ofen, auf dem PECVD-Boot abgeschiedenen Kohlenstoff und Bor, enthält.

Hierbei können bis zu etwa 20 Schichten übereinander angeordnet werden.

Die Schichtdicke der Beschichtung sollte insgesamt zwischen 0,1 µm und 5 µm liegen.

Mit einer solchen Beschichtung wird durch die besonders gute oder zumindest verbesserte elektrische Leitfähigkeit der Oberfläche der PECVD-Boote eine besonders gleichmäßige Ausbildung des Plasmas insbesondere auch zwischen den Wafern erreicht, sodass die auf den Wafern herzustellende Antireflexbeschichtung aus Siliziumnitrid eine deutlich verbesserte Homogenität aufweist.

Ein zur Herstellung der Schutzschicht geeignetes Verfahren ist dadurch gekennzeichnet, dass die Hartstoff-Beschichtung auf dem PECVD-Boot in der gleichen PECVD-Anlage vorgenommen wird, in der auch eine Antireflexbeschichtung auf Wafer aufgebracht wird.

Weiterhin erfolgt die Herstellung einer TiN-Schutzschicht durch Evakuieren und Aufheizen der PECVD-Anlage auf ca. 500 °C, Einleiten einer organischen Titanverbindung mit einem Trägergas, Zumischen von NH₃ als Reduktionsmittel und Zünden des für die Herstellung der Hartstoff-Beschichtung notwendigen Plasmas.

Das Ausbilden der Borcarbid-Schutzschicht erfolgt durch Aufheizen der PECVD-Anlage, oder eines Ofens, bei Atmosphärendruck auf ca. 1000 °C, Einleiten von Kohlenstoff und Bor in die PECVD-Beschichtungsanlage oder in den Ofen und Ausbilden der Borcarbid-Schutzschicht durch Reaktion auf der Oberfläche der PECVD-Boote zu Borcarbid.

Auch wenn die erfindungsgemäß ausgestatteten PECVD-Boote anderen Prozessen mit Sauerstoff bzw. Lachgas ausgesetzt werden, ist mit der erfindungsgemäßen Hartstoff-Beschichtung eine besonders gute Widerstandfestigkeit zu verzeichnen.

Insbesondere ist die erfindungsgemäße Hartstoff-Beschichtung besonders ätzresistent, sodass diese beim notwendigen Rückätzen mit HF nicht angegriffen wird, woraus eine erhebliche Verlängerung der Nutzungsdauer der Waferboote und auch der Verfügbarkeit der PECVD-Anlage resultiert.

Weitere Vorteile sind darin zu sehen, dass die bisher erforderliche Vorbelegung des PECVD-Bootes mit Siliziumnitrid sowie hierfür erforderliche Wafer nicht mehr notwendig sind.

Weiterhin unterliegen insbesondere die PECVD-Boote und die Haltepins durch die deutlich größere Härte der erfindungsgemäßen Hartstoff-Beschichtung gegenüber der bisher üblichen Beschichtung mit Siliziumnitrid einem geringeren Verschleiß.

Die daraus resultierende Kosteneinsparung beim Betrieb einer PECVD-Anlage kann einen siebenstelligen Betrag erreichen.

Schließlich kann die erfindungsgemäße Hartstoff-Beschichtung mit Titannitrid, Titancarbid oder Borcarbid auf dem PECVD-Boot in der gleichen PECVD-Anlage erfolgen, in der beispielsweise auch die Antireflexbeschichtung auf die Wafer aufgebracht wird.

Je nach den für die Hartstoff-Beschichtung auf den PECVD-Booten verwendeten Materialien, Titannitrid, Titancarbid oder Borcarbid, sind etwas unterschiedliche Verfahrensschritte in der PECVD-Anlage zu realisieren.

Zunächst ist es erforderlich, entweder neue PECVD-Boote oder PECVD-Boote, die bereits für die Herstellung von Antireflexbeschichtungen verwendet und rückgeätzt worden sind, in die PECVD-Anlage einzubringen.

Anschließend ist es für die Herstellung einer Titannitrid-Beschichtung erforderlich, die PECVD-Anlage auf ca. 500 °C aufzuheizen und zu evakuieren. Nach Einleiten beispielsweise einer organischen Titanverbindung mit einem Trägergas und Zumischen von NH₃ als Reduktionsmittel kann das für die Herstellung der Hartstoff-Beschichtung notwendige Plasma gezündet werden.

Die Zeitdauer dieses Vorganges ist von der Dicke der herzustellenden Hartstoff-Beschichtung, sowie der Anzahl der aufzubringenden Schichten, abhängig.

Die Herstellung einer Hartstoff-Beschichtung aus Borcarbid (B₄C) gestaltet sich hingegen etwas einfacher, weil hierfür weder ein Vakuum noch ein Plasma benötigt wird.

Das Beschichten der PECVD-Boote kann in einer PECVD-Anlage oder in einem geeigneten Ofen bei Atmosphärendruck vorgenommen werden, in dem die PECVD-Boote zunächst auf eine Temperatur von etwa 1.000 °C aufgeheizt werden. Anschließend werden aus geeigneten Quellen Kohlenstoff und Bor in den Ofen eingeleitet, wobei dann auf der Oberfläche der PECVD-Boote eine Reaktion zu Borcarbid erfolgt.

Die Herstellung einer Titancarbid-Beschichtung kann durch ein übliches CVD-Verfahren erfolgen.

Wenn die Beschichtung in einer PECVD-Anlage vorgenommen worden ist, sollte nach der Entnahme der PECVD-Boote eine Reinigung der Vakuum- bzw. Reaktionskammer vorgenommen werden, was beispielsweise durch Einleiten von Flusssäure erfolgen kann.

## Patentansprüche

1. Schutzschicht für PECVD-Boote aus Graphit zur Aufnahme von Wafern und zum Transport derselben in oder durch PECVD-Beschichtungsanlagen, insbesondere in der Photovoltaikindustrie, wobei das aus Graphit bestehende PECVD-Boot eine elektrisch leitfähige Hartstoff-Beschichtung mit einem mehrschichtigen Aufbau, bestehend aus Titannitrid und/oder Titancarbid, aufweist, **dadurch gekennzeichnet, dass** die elektrisch leitfähige Hartstoff-Beschichtung Borcarbid, bestehend aus in der PECVD-Beschichtungsanlage, oder einem Ofen, auf dem PECVD-Boot abgeschiedenem Kohlenstoff und Bor, enthält.

2. Schutzschicht nach Anspruch 1, **dadurch gekennzeichnet, dass** die Schichtdicke der Hartstoff-Beschichtung zwischen 0,1 µm und 5 µm liegt.

3. Verfahren zur Herstellung der Schutzschicht nach Anspruch 1 oder 2, **dadurch gekennzeichnet, dass** die Hartstoff-Beschichtung auf dem PECVD-Boot in der gleichen PECVD-Anlage vorgenommen wird, in der auch eine Antireflexbeschichtung auf Wafer aufgebracht wird.

4. Verfahren nach Anspruch 3, **gekennzeichnet durch** Evakuieren und Aufheizen der PECVD-Anlage auf ca. 500 °C, Einleiten einer organischen Titanverbindung mit einem Trägergas, Zumischen von NH₃ als Reduktionsmittel und Zünden des für die Herstellung der Hartstoff-Beschichtung notwendigen Plasmas.

5. Verfahren nach einem der Ansprüche 3 bis 4, **gekennzeichnet durch** Aufheizen der PECVD-Anlage, oder eines Ofens, bei Atmosphärendruck auf ca. 1000 °C, Einleiten von Kohlenstoff und Bor in die PECVD-Beschichtungsanlage oder in den Ofen und Ausbilden der Borcarbid-Schutzschicht durch Reaktion auf der Oberfläche der PECVD-Boote zu Borcarbid.

## Claims

1. Protective layer for PECVD boats made of graphite for receiving wafers and for transporting same in or through PECVD coating plants, in particular in the photovoltaics industry, wherein the PECVD boat composed of graphite has an electrically conductive hard-material coating with a multilayer construction composed of titanium nitride and/or titanium carbide, **characterized in that** the electrically conductive hard-material coating comprises boron carbide composed of boron and carbon deposited on the PECVD boat in the PECVD coating plant or in an oven.

2. Protective layer according to Claim 1, **characterized in that** the layer thickness of the hard-material coating is between 0.1 µm and 5 µm.

3. Process for producing the protective layer according to Claim 1 or 2, **characterized in that** the hard-material coating on the PECVD boat is effected in the same PECVD plant in which application of an antireflective coating to wafers also takes place.

4. Process according to Claim 3, **characterized by** evacuation and heating of the PECVD plant to about 500°C, introduction of an organic titanium compound with a carrier gas, admixing of NH₃ as reductant, and igniting of the plasma necessary for producing the hard-material coating.

5. Process according to either of Claims 3 and 4, **characterized by** heating of the PECVD plant, or of an oven, at atmospheric pressure to about 1000°C, introduction of carbon and boron into the PECVD coating plant or into the oven, and formation of the boron carbide protective layer by reaction to afford boron carbide on the surface of the PECVD boats.

## Revendications

1. Couche de protection pour nacelles de PECVD en graphite destinées à recevoir des plaquettes et à transporter ces dernières à l'intérieur ou au travers d'installations de revêtement de PECVD, notamment dans l'industrie photovoltaïque, la nacelle de PECVD constituée par du graphite comprenant un revêtement électriquement conducteur en un matériau dur présentant une structure multicouche, constitué par du nitrure de titane et/ou du carbure de titane, **caractérisée en ce que** le revêtement électriquement conducteur en un matériau dur contient du carbure de bore, constitué par du carbone et du bore déposés sur la nacelle de PECVD dans l'installation de revêtement de PECVD ou un four.

2. Couche de protection selon la revendication 1, **caractérisée en ce que** l'épaisseur de couche du revêtement en un matériau dur est comprise entre 0,1 µm et 5 µm.

3. Procédé de fabrication de la couche de protection selon la revendication 1 ou 2, **caractérisé en ce que** le revêtement en un matériau dur sur la nacelle de PECVD est réalisé dans la même installation de PECVD que celle dans laquelle un revêtement antireflet est également appliqué sur une plaquette.

4. Procédé selon la revendication 3, **caractérisé par** une évacuation et un chauffage de l'installation de PECVD à environ 500 °C, l'introduction d'un composé de titane organique avec un gaz vecteur, l'incorporation de NH₃ en tant que réducteur et l'allumage du plasma nécessaire pour la fabrication du revêtement en un matériau dur.

5. Procédé selon l'une quelconque des revendications 3 à 4, **caractérisé par** un chauffage de l'installation de PECVD, ou d'un four, à la pression atmosphérique à environ 1 000 °C, l'introduction de carbone et de bore dans l'installation de revêtement de PECVD ou dans le four, et la formation de la couche de protection en carbure de bore par réaction sur la surface des nacelles de PECVD pour former du carbure de bore.
